# EUROPEAN PATENT APPLICATION

(11) **EP 1 650 797 A2**
(43) Date of publication of application: **26.04.2006**
(21) Application number: 05019681.5
(22) Date of filing: 09.09.2005
(51) Int. Cl.: H01L 23/045, H01L 23/498

(54) **Wiring apparatus , protecting cap for device package using the same, and a method for manufacturing them**

(30) Priority: 20.10.2004 KR 2004083856
(71) Applicant: Samsung Electronics Co., Ltd., Yeongtong-gu Suwon-si, Gyeonggi-do (KR)
(72) Inventor: Chung, Seok-whan, Yeongtong-gu Suwon-si Gyeonggi-do (KR); Lee, Moon-chul, Suwon-si Gyeonggi-do (KR); Kim, Woon-bae, Yeongtong-gu Suwon-si Gyeonggi-do (KR)
(74) Representative: Grünecker, Kinkeldey, Stockmair & Schwanhäusser Anwaltssozietät

(57) **Abstract**

A wiring apparatus including a substrate, a via-hole penetrating the substrate, a buffer layer formed on an inner surface of the via-hole, and a plating layer filling filing the via hole inside of the buffer layer. When the wiring apparatus is applied to a protecting cap for device package, a difference in thermal expansion coefficient generated between the substrate and the plating layer can be compensated, thereby preventing damage to the packaging substrate even upon application of thermal impact. Methods for fabricating the wiring apparatus and a protecting cap for a device package using the above wiring processes are also disclosed.

## Description

### CROSS-REFERENCE TO RELATED APPLICATIONS

This application claims benefit under 35 U.S.C. § 119(a) of Korean Patent Application No. 2004-83856, filed October 20, 2004, the entire contents of which are incorporated herein by reference.

### BACKGROUND OF THE INVENTION

### 1. Field of the invention

The present invention relates to a wiring apparatus, a protecting cap for a device package using the same, and a method for manufacturing the wiring apparatus and protecting cap.

### 2. Description of the Related Art

Common devices used in a variety of electronic apparatuses receive power from an external device to perform independent functions. Since the device includes a delicate micro-electronic circuit, a package is provided for electrical connection of the device and to shield the device from external impact. Especially, wafer leveling packaging has recently been more widely used for miniaturization and high performance of electronic apparatuses. Different from a conventional packaging method which separately packages individual devices fabricated on a substrate, wafer leveling packaging can simultaneously package a number of devices arranged on the substrate.

For wafer leveling packaging, in general, a protecting cap of a certain form is bonded to the substrate comprising the devices.

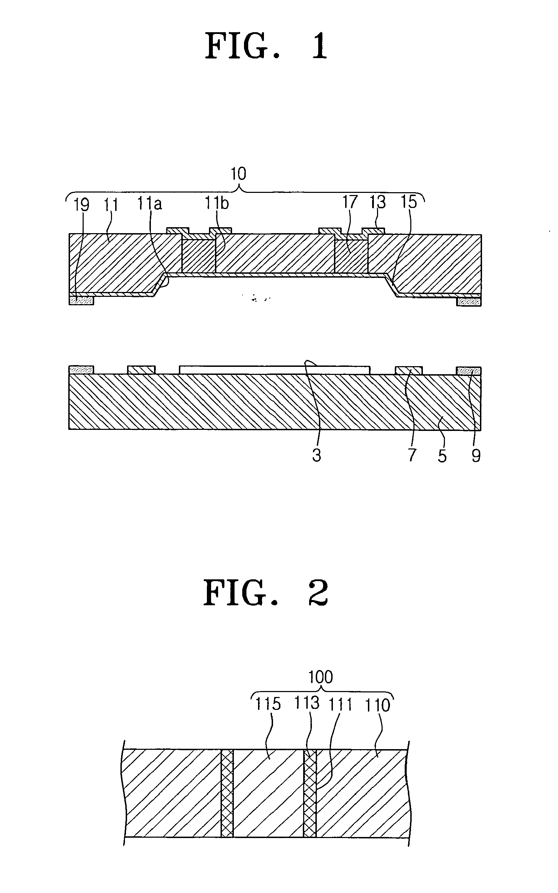

FIG. 1 is a vertical sectional view showing a protecting cap 10 bonded to a conventional device substrate.

FIG. 1 shows a substrate 5 comprising a device 3, and the protecting cap 10 bonded to an upper surface of substrate 5 to package the device 3.

The protecting cap 10 comprises a packaging substrate 11 including a space 11a for receiving the device 3 at one surface which faces the device 3. Upper and lower electrode layers 13 and 15 are vapor-deposited on upper and lower surfaces of the packaging substrate 11. The upper and the lower electrode layers 13 and 15 are connected to each other through a plating layer 17 formed by filling a via-hole 11b that penetrates the packaging substrate 11 with a conductive material using a plating technique. The lower electrode layer 15 is connected to an electrode layer 7 of the device 3 while the upper electrode layer 13 is connected to an external electrode (not shown). In addition, a packaging bonding layer 19 is formed on the outside of the space 11a of a lower surface of the packaging substrate 11. Also, a device bonding layer 9 for bonding with the packaging bonding layer 19 is formed on the device substrate 5.

The above wiring process of forming the via-hole 11b on the packaging substrate 11 and filling the via-hole 11b with the plating layer 17 is not limited to the protecting cap 10 but is applicable to other structures used for interlayer wiring. The interlayer wiring refers to a connection between electrodes formed on upper and lower portions of a substrate by penetrating the substrate.

Several wiring processes as above have been proposed.

For example, U.S. Patent Application Publication No. 2002-021920 discloses a structure wherein a metal electrode is formed in the via-hole of a substrate so as to electrically connect a capacitor of a first surface and an inductor of a second surface.

Another example is disclosed in Japanese Patent Laid-Open No. 2002-141437, where a polyamide film, formed by designing a conductive thin film on a wafer terminal surface, is attached and a via-hole is formed in a floating-electrode area of a semiconductor chip of the polyamide film. Additionally, a non-electrolytic plating layer is formed in connection with the conductive thin film to electrify the via-hole, and the plating layer is wired in connection with a wafer pad.

However, due to a difference in coefficient of thermal expansion between the plating layer 17 and the packaging substrate 11 of FIG. 1, a notch or a crack may occur in the substrate 11 during a reliability test, for example, when thermal impact is applied in a high temperature environment.

Although the difference in coefficient of thermal expansion could be overcome by reducing the diameter of the via-hole 11b, formation of a smaller via-hole 11b is very difficult.

The metal electrode formed in the via-hole and the substrate disclosed by U.S. Patent Application Publication No. 2002-021920 and the plating layer and the film layer disclosed by Japanese Patent Laid-Open No. 2002-141437 also have the same problem.

### SUMMARY OF THE INVENTION

The present invention has been made to at least solve the above problems and/or disadvantages and to provide the advantages described below. Accordingly, a first object of the present invention is to provide a wiring apparatus capable of compensating for differences in coefficient of thermal expansion between a plating layer and a substrate, when wiring the substrate by forming the plating layer through a via-hole.

A second object of the present invention is to provide a protecting cap for a device package, capable of preventing damage to the substrate in the wiring apparatus.

A third object of the present invention is to provide a method for fabricating the above wiring apparatus.

A fourth object of the present invention is to provide a method for fabricating the above protecting cap for a device package.

The above first object of the present invention has been achieved by providing a wiring apparatus comprising a substrate, a via-hole penetrating the substrate, a buffer layer formed on an inner surface of the via-hole, and a plating layer filling the via hole inside of the buffer layer.

The buffer layer preferably comprises a polymer. Preferably, the buffer layer comprises PARYLENE (commercial name for poly-para-xylylene) or photoresist.

The above second object of the present invention has been achieved by providing a protecting cap for a device package, comprising a packaging substrate having at one side thereof a space for receiving a device, an upper electrode layer formed on an upper surface of the packaging substrate, a lower electrode layer formed on a lower surface of the packaging substrate, a via-hole penetrating the packaging substrate, a buffer layer formed on an inner surface of the via-hole, and a plating layer filling the via hole inside of the buffer layer to connect the upper and the lower electrode layers.

The buffer layer can comprise a polymer. Preferably, the buffer layer comprises PARYLENE or photoresist.

The above third object of the present invention has been achieved by providing a method for fabricating a wiring apparatus, which comprises the steps of forming a plating seed layer on a lower surface of a substrate, forming a via-hole in the substrate, forming a buffer layer of a predetermined thickness on an upper horizontal surface of the substrate and on an inner vertical surface of the via-hole, removing horizontally facing planes of the buffer layer, and forming a plating layer in the via hole inside of the buffer layer.

The buffer layer can comprise a polymer. Preferably, the buffer layer comprises PARYLENE or photoresist.

The plating layer can be formed by electrolytic plating or non-electrolytic plating.

In the removing step, preferably the horizontally facing planes are removed by reactive ion etching.

Preferably, the photoresist is applied using a spin coater when forming the photoresist buffer layer.

The buffer layer can also be formed by evaporating the PARYLENE using an evaporator, thermally decomposing the PARYLENE in a thermal-decomposition area and supplying the PARYLENE to a vacuum chamber, thereby adhering the PARYLENE to a substrate introduced into the vacuum chamber.

The above fourth object of the present invention has been achieved by providing a method for fabricating a protecting cap for a device package, which comprises providing a packaging substrate having at one side thereof a space for receiving a device, forming a lower electrode layer on the side of the substrate having the space, forming a via-hole in the substrate fluidly connecting to the lower electrode layer on the packaging substrate, forming a buffer layer in a predetermined thickness on an upper horizontal surface of the packaging substrate and on an inner vertical surface of the via-hole, removing horizontally facing planes of the buffer layer, forming a plating layer in the via hole inside of the buffer layer, and forming an upper electrode layer on the upper surface of the packaging substrate electrically connecting to the plating layer.

The buffer layer can comprise a polymer. Preferably, the buffer layer comprises PARYLENE or photoresist.

The plating layer can be formed by electrolytic plating or non-electrolytic plating.

In forming the plating layer, the lower electrode layer can be used as a plating seed layer.

In the removing step, the horizontally facing planes can be removed by reactive ion etching.

Preferably, the photoresist is applied using a spin coater when forming a photoresist buffer layer.

The buffer layer can also be formed by evaporating the PARYLENE using an evaporator, thermally decomposing the PARYLENE in a thermal-decomposition area and supplying the PARYLENE to a vacuum chamber, thereby adhering the PARYLENE to a substrate present in the vacuum chamber.

### BRIEF DESCRIPTION OF THE DRAWINGS

The above objects and other features of the present invention will become more apparent by describing in detail exemplary embodiments thereof with reference to the attached drawing figures, wherein;

FIG. 1 is a vertical sectional view showing a protecting cap 10 being bonded to a conventional device substrate;

FIG. 2 is a view showing a wiring structure according to an embodiment of the present invention;

FIG. 3 is a view of a protecting cap for a device package, employing the wiring structure of FIG. 2;

FIGS. 4A through 4G are views illustrating the processes for fabricating the wiring structure of FIG. 2; and

FIGS. 5A through 5H are sectional views illustrating the processes for fabricating the protecting cap for the device package of FIG. 3.

### DETAILED DESCRIPTION OF THE EXEMPLARY EMBODIMENTS

Hereinafter, certain embodiments of the present invention will be described in detail with reference to the accompanying drawing figures. However, the present invention should not be construed as being limited thereto.

In the following description, the same drawing reference numerals are used for identifying the same elements in the various drawings. The subject matter defined in the detailed description such as a detailed construction and structural elements are provided to assist in a comprehensive understanding of the invention. Thus, it is apparent that the present invention can be carried out without being specifically limited thereto. Also, well-known functions or constructions are not described in detail since they would obscure the invention in unnecessary detail.

FIG. 2 shows a wiring structure 100 according to an embodiment of the present invention.

Referring to FIG. 2, a via-hole 111 is formed on the substrate 110. A buffer layer 113 is formed on an inner surface of the via-hole 111 and a plating layer 115 fills the via hole inside of the buffer layer 113.

The buffer layer 113 compensates for a difference in thermal expansion coefficient between the substrate 110 made of silicon (Si) and the plating layer 115 made of a conductive metal. For this purpose, the buffer layer 113 can comprise PARYLENE or photoresist as the polymer which is an insulator. The photoresist may comprise polymer such as Novolak resin.

Therefore, although there is a difference in thermal expansion coefficient between the substrate 110 and the plating layer 115 in high temperature environments, elasticity of the buffer layer 113 can prevent breakage or damage to the substrate 110.

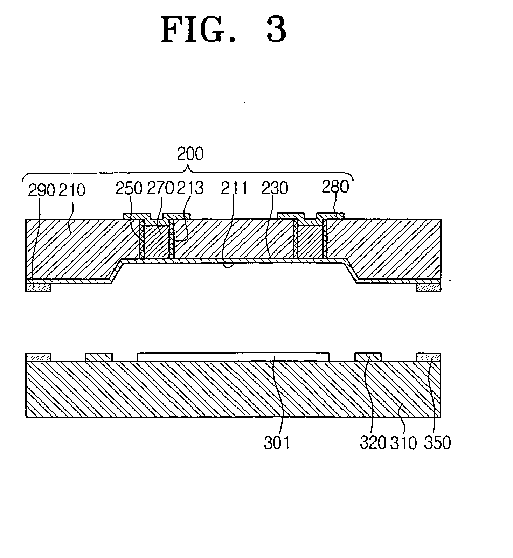

FIG. 3 illustrates the wiring structure 100 of FIG. 2 mating to a protecting cap 200 for providing a device package.

Referring to FIG. 3, a device 301 is mounted on a surface of a device substrate 310, and a protecting cap 200 is connected to an external electrode to protect the device 301 from external impact.

The protecting cap 200 includes a packaging substrate 210 having at one side thereof a space 211 for receiving the device 301. A lower electrode layer 230 is formed on a first side, having the space 211, of the packaging substrate 210. The lower electrode layer 230 is connected to a device electrode layer 320 formed on the device substrate 310.

A via-hole 213 is formed in the packaging substrate 210 and a buffer layer 250 is formed on an inner surface of the via-hole 213. A plating layer 270 made of conductive metal fills the via hole inside of the buffer layer 250.

In addition, an upper electrode layer 280 is formed on the packaging substrate 210 in connection with the plating layer 270. By connecting the external electrode with the upper electrode layer 280, a driving signal can be transmitted to the device 301. A packaging bonding layer 290 is additionally deposited on a lower surface of the lower electrode layer 230 and bonded to a device bonding layer 350 formed on the device substrate 310. Thus, the device 301 can be protected from the external environment.

As explained with reference to FIG. 2, the buffer layer 250 compensates for a difference in thermal expansion coefficient between the packaging substrate 210 and the plating layer 270. Therefore, when performing a reliability test in a high temperature environment, breakage or damage to the packaging substrate 210, which may be generated due to the difference in thermal expansion coefficient, can be prevented The buffer layer 250, as an insulator, isolates the upper electrode layer 280 and the packaging substrate 210.

Hereinbelow, a method for fabricating the wiring structure 100 and the protecting cap 200 for preparing a device package will be described.

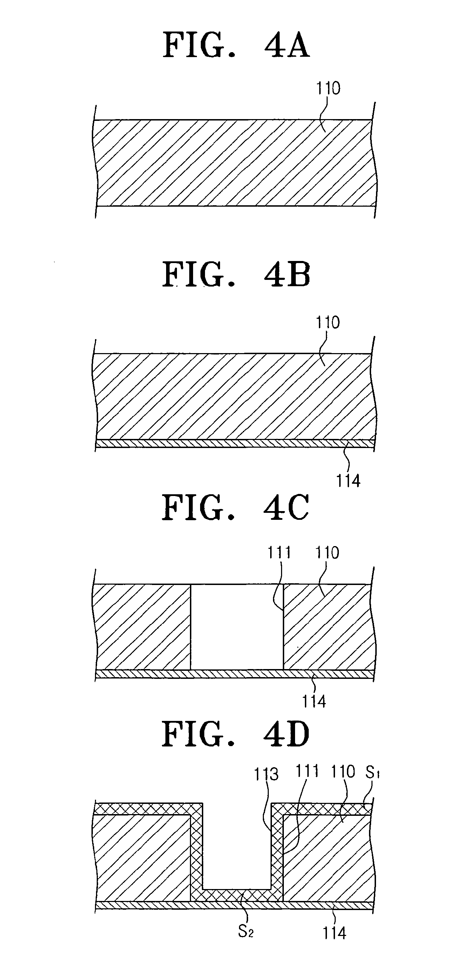

FIGS. 4A through 4G are views illustrating the processes for fabricating the wiring structure 100 of FIG. 2.

FIG. 4A shows the substrate 110 which may be made of silicon (Si).

Referring to FIG. 4B, a metal layer 114 is deposited for use as a seed layer for electrolytic plating or non-electrolytic plating of the plating layer 115. The metal layer 114 may comprise a conductive metal.

Referring to FIG. 4C, the substrate 110 is etched by an etching device to form the via-hole 111 in a predetermined size.

In FIG. 4D, a buffer layer 113 is deposited on an upper surface of the substrate 110 having the via-hole 111. The buffer layer 113 may comprise an insulating polymer, more preferably PARYLENE or photoresist.

PARYLENE can be deposited by evaporating with an evaporator, thermally decomposing in a thermal-decomposition area and supplying to a vacuum chamber, thereby adhering the PARYLENE to a substrate introduced into the vacuum chamber.

When depositing the photoresist, a spin coater can be used. More specifically, the substrate 110 is seated on a rotator and liquid photoresist is sprayed on an upper surface of the substrate 110 using a nozzle. The liquid photoresist is evenly coated on the substrate 110 by centrifugal force of the rotator, thereby forming a photoresist film. PARYLENE is preferably used because it forms a deposited film of more even thickness (conformal coating).

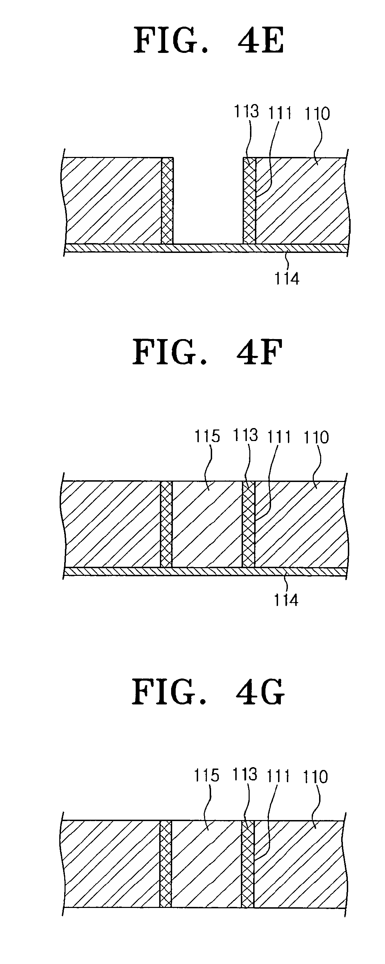

Referring to FIG. 4E, horizontal planes S and S2 (FIG. 4D) of the buffer layer 113 are removed by reactive ion etching, so that only a vertical plane is left on an inner surface of the via-hole 111.

Referring to FIG 4F, a predetermined plating process such as electrolytic plating or non-electrolytic plating is performed so as to fill a plating layer 115 formed of conductive metal in the via-hole 111. Here, the metal layer 114 serves as a plating seed layer.

In FIG. 4G, the wiring of substrate 110 is completed by removing metal layer 114.

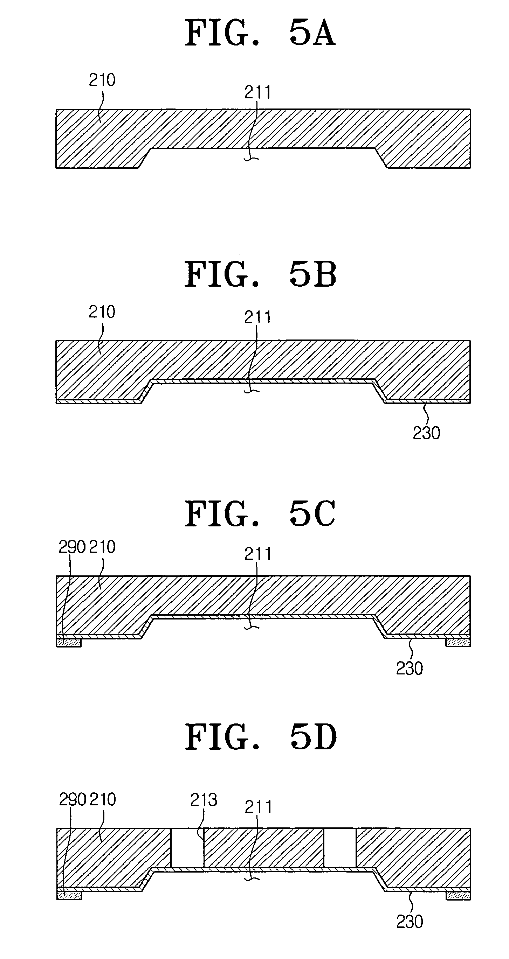

FIGS. 5A through 5H are sectional views illustrating a process for fabricating the protecting cap 200 of the device package of FIG. 3.

FIG. 5A shows the packaging substrate 210 having at one side thereof a space 211 for receiving the device 301.

Referring to FIG. 5B, the lower electrode layer 230 made of conductive metal is deposited on a first side of the packaging substrate 210, which has the space 211. The lower electrode layer 230 is connected to the device electrode layer 320 as shown in FIG. 3.

Referring to FIG. 5C, a packaging bonding layer 290 is deposited for connecting with the device bonding layer 350 of FIG. 3. As well as the device bonding layer 350, the packaging bonding layer 290 functions as a sealing member.

Referring to FIG. 5D, a via-hole 213 is etched in the packaging substrate 210 in a predetermined size by the etching device.

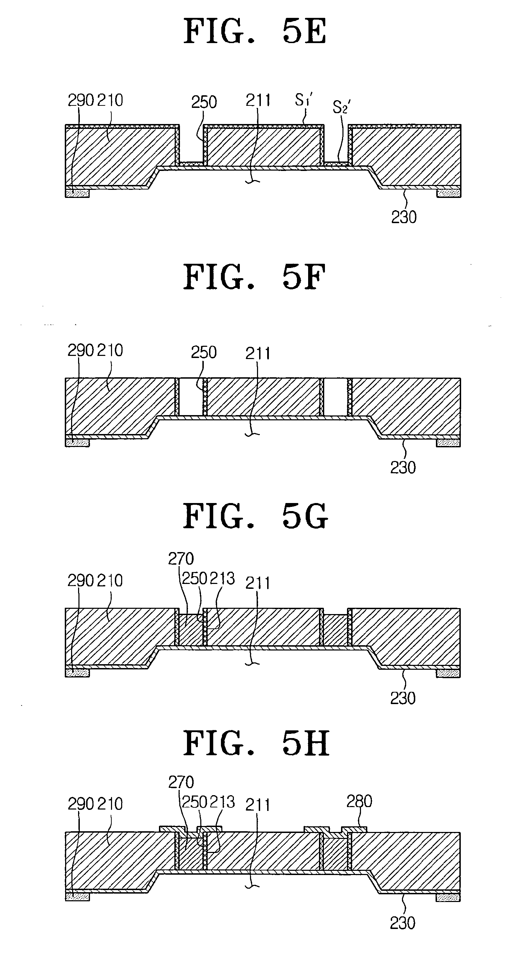

Referring to FIG. 5E, a buffer layer 250 is deposited in a predetermined thickness on the upper surface of the packaging substrate 210 and on the inside of the via-hole 213. The buffer layer 250 can be formed using the same material and method as the buffer layer 113. Therefore, a detailed description thereof is provided by reference to the description of FIG. 4D.

Referring to FIG. 5F, in the same manner as in FIG. 4E, horizontal planes S₁' and S₂' (FIG. 5E) of the buffer layer 250 are removed by reactive ion etching, so that only a vertical plane formed on an inner surface of the via-hole 111 rerimains.

Referring to FIG. 5G, a predetermined plating process such as electrolytic plating or non-electrolytic plating is performed so as to fill a plating layer 270 formed of conductive metal in the via-hole 213. Here, the lower electrode layer 230 serves as a plating seed layer.

Referring to FIG. 5H, an upper electrode layer 280 is deposited on the upper surface of the packaging substrate 210 so as to connect with the lower electrode layer 230 via the plating layer 270.

According to the above description, the buffer layer 250 is arranged between the packaging substrate 210 and the plating layer 270 to compensate for a difference in thermal expansion coefficient between the plating layer 270 and the packaging substrate 210, and such structure is applied to the protecting cap 200 for providing a device package. However, the above structure is also applicable to an interlayer wiring structure comprising multi-layers.

As can be appreciated from the above description of the wiring apparatus and the protecting cap for a device package, according to embodiments of the present invention, damage to the device by external thermal impact can be prevented. This is achieved by compensating for a difference in thermal expansion coefficient between the plating layer and the substrate using the buffer layer.

While the invention has been shown and described with reference to certain embodiments thereof, it will be understood by those skilled in the art that various changes in form and detail may be made therein without departing from the spirit and scope of the invention as defined by the appended claims.

## Claims

1. A wiring apparatus comprising:
a substrate;
a via-hole penetrating the substrate;
a buffer layer formed on an inner surface of the via-hole; and
a plating layer filling the via hole inside of the buffer layer.

2. The wiring apparatus of claim 1, wherein the buffer layer comprises a polymer.

3. The wiring apparatus of claim 2, wherein the buffer layer comprises PARYLENE or photoresist.

4. A protecting cap for a device package, said protecting cap comprising:
a packaging substrate having at one side thereof a space for receiving a device;
an upper electrode layer formed on an upper surface of the packaging substrate;
a lower electrode layer formed on a lower surface of the packaging substrate;
a via-hole penetrating the packaging substrate;
a buffer layer formed on an inner surface of the via-hole; and
a plating layer filling the via hole inside of the buffer layer so as to connect the upper and the lower electrode layers.

5. The protecting cap for a device package of claim 4, wherein the buffer layer comprises a polymer.

6. The protecting cap for a device package of claim 5, wherein the buffer layer comprises PARYLENE or photoresist.

7. A method for fabricating a wiring apparatus, which comprises:
forming a plating seed layer on a lower surface of a substrate;
forming a via-hole in the substrate;
forming a buffer layer of predetermined thickness on an upper horizontal surface of the substrate and on an inner vertical surface of the via-hole;
removing horizontally facing planes of the buffer layer; and
forming a plating layer in the via hole inside of the buffer layer.

8. The method of claim 7, wherein the buffer layer comprises a polymer.

9. The method of claim 7, wherein the buffer layer comprises PARYLENE or photoresist.

10. The method of claim 7, wherein the plating layer is formed by electrolytic plating or non-electrolytic plating.

11. The method of claim 7, which comprises removing the horizontally facing planes by reactive ion etching.

12. The method of claim 9, which comprises spin coating photoresist onto the substrate to form said buffer layer.

13. The method of claim 9, which comprises evaporating PARYLENE using an evaporator, thermally decomposing the PARYLENE in a thermal-decomposition area and supplying the PARYLENE to a vacuum chamber, thereby adhering the PARYLENE to a substrate introduced into the vacuum chamber to form said buffer layer.

14. A method for fabricating a protecting cap for a device package, which comprises:
providing a packaging substrate having at one side thereof a space for receiving a device;
forming a lower electrode layer on the side of the substrate having the space;
forming a via-hole in the substrate fluidly connecting to the lower electrode layer on the packaging substrate;
forming a buffer layer in a predetermined thickness on an upper horizontal surface of the packaging substrate and on an inner vertical surface of the via-hole;
removing horizontally facing planes of the buffer layer;
forming a plating layer in the via hole inside of the buffer layer, and
forming an upper electrode layer on the upper surface of the packaging substrate electrically connecting to the plating layer.

15. The method of claim 14, wherein the buffer layer comprises a polymer.

16. The method of claim 14, wherein the buffer layer comprises PARYLENE or photoresist.

17. The method of claim 14, wherein the plating layer is formed by electrolytic plating or non-electrolytic plating.

18. The method of claim 17, which comprises using the lower electrode layer as a plating seed layer in forming the plating layer.

19. The method of claim 14, wherein said removing step comprises removing the horizontally facing planes by reactive ion etching.

20. The method of claim 16, which comprises spin coating photoresist onto the substrate to form said buffer layer.

21. The method of claim 16, which comprises evaporating PARYLENE using an evaporator, thermally decomposing the PARYLENE in a thermal-decomposition area and supplying the PARYLENE to a vacuum chamber, thereby adhering the PARYLENE to a substrate introduced into the vacuum chamber to form said buffer layer.
